# EUROPÄISCHE PATENTSCHRIFT

(11) **EP 1 842 074 B1**
(45) Veröffentlichungstag und Bekanntmachung des Hinweises auf die Patenterteilung: **07.10.2009**
(21) Anmeldenummer: 06704234.1
(22) Anmeldetag: 13.01.2006
(51) Int. Cl.: G01R 33/34

(54) **HF - SPULEN F]R KERNSPINTOMOGRAPHEN**
RF COILS FOR MAGNETIC RESONANCE TOMOGRAPHS
BOBINES A HAUTE FREQUENCE POUR TOMOGRAPHES A RESONANCE MAGNETIQUE NUCLEAIRE

(30) Priorität: 14.01.2005 DE 102005002094; 29.06.2005 DE 102005030744
(43) Veröffentlichungstag der Anmeldung: 10.10.2007
(73) Patentinhaber: Schleifring und Apparatebau GmbH, 82256 Fürstenfeldbruck (DE)
(72) Erfinder: SCHILLING, Harry, 85072 Eichstätt (DE)
(74) Vertreter: Lohr, Georg
(86) Internationale Anmeldenummer: PCT/EP2006/000269
(87) Internationale Veröffentlichungsnummer: WO 2006/074943

(56) Entgegenhaltungen:
- WO-A-99/15914
- FR-A- 2 557 298
- US-A- 5 990 681

## Beschreibung

### Technisches Gebiet

Die Erfindung bezieht sich auf die Kernspintomographie und insbesondere auf medizinische Geräte zur Untersuchung von menschlichen und tierischen Körpern. Die Kernspintomographie wird auch als Magnetresonanztomographie, abgekürzt MRT, bezeichnet.

### Stand der Technik

Die MRT ist ein bildgebendes Verfahren, welches auf dem physikalischen Phänomen der Kernspinresonanz basiert. Das zu untersuchende Objekt wird einem starken Magnetfeld ausgesetzt. Durch dieses richten sich die Kernspins der einzelnen Atome aus, welche zuvor statistisch verteilt waren. Durch eine äußere Anregung mit hochfrequenter Energie wird eine messbare Schwingung angeregt. Um nun eine räumliche Lokalisierung zu ermöglichen, werden in dem Magnetfeld durch Gradientenspulen in den drei Raumachsen inhomogene Magnetfelder erzeugt. Zur Aussendung der hochfrequenten Anregungsenergie sind Sendespulen vorgesehen. Der Empfang der angeregten Schwingungen erfolgt durch Empfangsspulen. Vielfach sind auch Sendespulen und Empfangsspulen miteinander kombiniert. Diese Spulen werden nachfolgend auch als HF-Spulen bezeichnet, da sie zur Einkopplung bzw. Auskopplung der hochfrequenten Signale dienen.

Durch dieses nichtinvasive bildgebende Verfahren können Schnittbilder in beliebigen Achsen durch den menschlichen oder tierischen Körper aufgenommen werden.

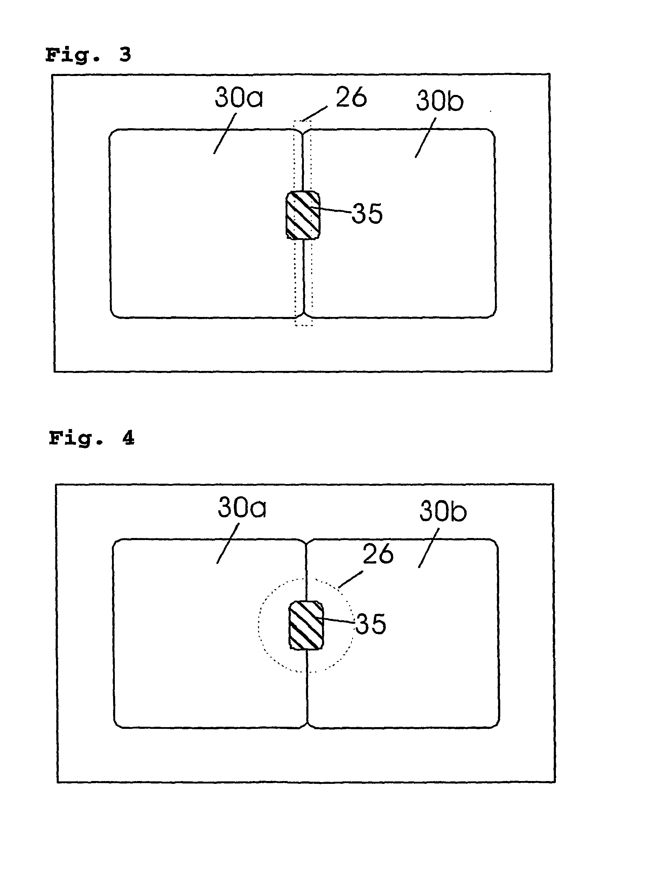

Beispielhafte Sende- bzw. Empfangsspulen sind in der US 4,887,039 offenbart. Dort sind auf einem zylinderförmigen Träger 11 mehrere parallele Leiter 18 angebracht, welche durch Koppelkondensatoren 16 miteinander verbunden sind. Die Speisung erfolgt mittels symmetrischer Leitungen 19 oder Koaxialkabel 20. Sogenannte phasedarray Anordnungen, wie sie in Fig. 4 dieser Patentschrift dargestellt sind, werden eingesetzt, um höhere Auflösungen zu erzielen. Hierbei sind mehrere unabhängige Spulen mit unabhängigen Empfängereingängen zur getrennten Auswertung der Signale verbunden.

Der Aufbau solcher Spulen ist sehr komplex und die Herstellungskosten sind demzufolge relativ hoch. Bei zukünftigen Spulenanordnungen werden immer mehr Spulen vorzusehen sein, wobei aufgrund der höheren Auflösung auch höhere Anforderungen an die mechanischen Toleranzen gestellt werden.

Aufgabe der Erfindung ist es, eine Spulenanordnung vorzustellen, welche unter Beibehaltung bzw. Verbesserung der elektrischen Eigenschaften eine Vereinfachung des mechanischen Aufbaus und damit eine Reduzierung der Herstellkosten ermöglicht. Gleichzeitig sollten die mechanischen Toleranzen weiter reduziert werden.

In der US 5,990,681 ist eine Spule für Kernspintomografen offenbart. Diese Spule ist in Leiterplattentechnik aufgebaut und umfasst Kapazitäten, welche mit Anschlusselementen verbunden sind.

Eine erfindungsgemäße Lösung dieser Aufgabe ist in dem unabhängigen Patentanspruch angegeben. Weiterbildungen der Erfindung sind Gegenstand der abhängigen Ansprüche.

Eine erfindungsgemäße Spulenanordnung umfasst einen mehrschichtigen Aufbau, wobei wenigstens zwei Schichten vorzugsweise in Form eines Laminats miteinander verbunden sind. Wenigstens eine Schicht umfasst ein dielektrisches Isolationsmaterial 10,12 (Isolatorschicht), welches vorzugsweise in dem Arbeitsfrequenzbereich der Spulenanordnung möglichst niedrige dielektrische Verluste aufweist. Solche Materialien können beispielsweise Kunststoffe wie PTFE (Polytetrafluorethylen), PE (Polyethylen), oder auch Keramikmaterialien umfassen.
Zu Erhöhung der mechanischen Stabilität können auch Fasern wie Glasfasern oder Kohlenstofffasern eingebettet sein.

Ein typischer Arbeitsfrequenzbereich solcher Spulenanordnungen liegt im Bereich von 30 MHz bis einige 100 MHz entsprechend dem jeweiligen äußeren Magnetfeld der Anordnung. Fest mit diesem Träger-material verbunden ist wenigstens eine Schicht 20,21 aus leitendem Material (Leiterschicht), wobei in dieser Schicht die Form der Spulen ausgearbeitet ist. Eine Verbindung zwischen den Schichten bzw. die Schichten selbst können auch semiflexibel sein, so dass beim Verbiegen der Anordnung innere Spannungen nicht auftreten können bzw. reduziert werden. Eine leitende Schicht kann wahlweise durch chemische bzw. galvanische Verfahren insbesondere durch galvanischen Auftrag oder Ätzen oder auch mechanisch auf die erste Trägerschicht aufgebracht werden. So kann diese beispielsweise in Form einer dünnen Folie aufgewalzt werden.

Derartige Spulenanordnungen können auch in Multilayer - Technik ausgebildet sein, um mehrere, wahlweise konzentrische, oder sich zumindest teilweise überlappende Spulen auf unterschiedlichen Lagen anzuordnen. Hierbei sind weitere Leiterschichten vorhanden, wobei jeweils zwischen zwei Leiterschichten eine Schicht aus Isoliermaterial vorgesehen ist. Solche Spulenanordnungen können nicht nur außen am Patienten angebracht werden, sondern auch ins Körperinnere eingeführt werden. Hierzu werden sie vorteilhafterweise flexibel und somit biegbar oder auch aufrollbar ausgeführt.

Erfindungsgemäß können flexible Anordnungen durch wenigstens eine als leitfähige Schicht ausgebildete Spule auf wenigstens einer fleiblen Kunsttoffolie realisiert werden. Um eine Verkopplung mit definierten höheren Impedanzen mit anderen Spulen zu erreichen, kann zwischen Spulen eine Schicht aus einem schaumförmigen Dielektrikum, beispielsweise aus einem Polyethylen-Schaum vorgesehen sein. Durch den Schaum wird bei gegebener Materialdicke die Dielektrizitätskonstante verringert und auch der dielektrische Verlustfaktor reduziert. Dadurch lassen sich auch die elektrischen Verluste der Spulen reduzieren bzw. deren Güten (Q) erhöhen. Alternativ zu einem Schaum kann auch ein wabenförmiges bzw. aus Waben bestehendes Material eingesetzt werden. Besonders günstig ist die Kombination mit wenigstens einer Kunststoffolie und wenigstens einem schaumförmigen Dielektrikum.

Eine andere Ausgestaltung der Erfindung sieht vor, dass unterschiedliche Spulen in unterschiedlichen Leiterschichten ausgebildet sind, welche jeweils durch isolierende Schichten voneinander getrennt sind. Zur Erläuterung wird auf Fig. 4 der US 4,887,039 Bezug genommen. So ist beispielsweise die Spule 40-1 in einer ersten Leiterschicht realisiert. Die Spule 40-2 liegt in einer zweiten Leiterschicht, welche von der ersten Leiterschicht durch eine Schicht aus isolierendem Material getrennt ist. Die Spule 40-3 kann nun wahlweise in einer dritten Leiterschicht oder aber in der ersten Leiterschicht liegen. Im Falle einer dritten Leiterschicht ist diese wiederum durch eine isolierende Schicht von der zweiten Leiterschicht getrennt. Wahlweise können auch die Speiseleitungen der Spulen in einer eigenen Leiterschicht ausgebildet werden. Alternativ können die Speiseleitungen in schirmende Flächen eingebettet als Streifenleitungen (Striplines) ausgeführt werden. Die Abstimmung der Spulen zueinander erfolgt durch die Positionierung der Spulen auf den einzelnen Lagen. Ungenauigkeiten können beispielsweise durch optische Ausrichtung anhand von markierungen vermieden werden. Um eine nachträgliche Abstimmung zu ermöglichen, sind mehrere Spulen und/oder Anordnungen aus einer oder mehreren Leiterschichten bzw. Isolatorschichten verschiebbar gegeneinander angeordnet, d.h. nicht miteinander verklebt oder laminiert.

In einer anderen Ausgestaltung ist erfindungsgemäß in wenigstens einer Schicht 10, 12 aus isolierendem Material und wahlweise zusätzlich wenigstens einer Schicht 20,21 umfassend elektrisch leitfähiges Material wenigstens eine Aussparung 25 zur Aufnahme von wenigstens einem diskreten Bauelement 35 vorgesehen.

In einer weiteren vorteilhaften Ausgestaltung der Erfindung umfassen die diskreten Bauelemente wahlweise Spulen, Widerstände und auch Halbleiter, wie beispielsweise Dioden. Diese Bauelemente sind vorzugsweise in SMD-Technik ausgeführt, um eine besonders Platz sparende und effiziente Montage zu ermöglichen. Weiterhin werden durch derartige Bauelemente die hochfrequenztechnischen Eigenschaften verbessert und die Beeinflussung des Magnetfeldes reduziert.

In der Erfindung sind zusätzliche Versteifungen vorgesehen, um die mechanische Stabilität der gesamten Anordnung weiter zu erhöhen. Besonders kritisch sind die Stellen der Anordnung, an denen Aussparungen vorgesehen sind, beziehungsweise an denen verschiedene Teile der Leiterplatten beziehungsweise Schichten aus isolierendem Material aneinander gefügt sind. Hier kommt es bei mechanischer Beanspruchung der gesamten Anordnung vorzugsweise zu Rissen oder Brüchen. Um diese zu vermeiden sind zusätzliche Versteifungen vorgesehen.

Vorteilhafterweise können derartige Versteifungen in Form von Streifen, Käfigen oder auch Ringen ausgebildet sein. Streifenförmige Anordnungen können beispielsweise auch in Gitterstruktur vorgesehen sein.

Besonders vorteilhaft ist es, wenn die Versteifungen ein Kunststoffmaterial umfassen. Besonders günstig ist der Einsatz von faserverstärkten (Glasfaser, Kohlefaser, etc.) Kunststoffen.

Weiterhin ist es vorteilhaft, wenn mehrere Versteifungen zur Erhöhung der gesamten Stabilität miteinander verbunden sind.

In einer besonderen Ausgestaltung der Erfindung ist wenigstens eine der Versteifungen vorzugsweise durch Kleben an der Oberfläche der Anordnung fixiert.

Weiterhin kann Vorteilhafterweise zumindest eine er Versteifungen vorzugsweise durch Verpressen oder Eingießen in die Anordnung selbst integriert sein.

Eine vorteilhafte Weiterbildung besteht in Maßnahmen zur Verringerung der mechanischen Spannungen, insbesondere zur Verringerung der Kerbspannungen. Dies können beispielsweise Bohrungen, Ausfräsungen und andere sein.

In einer weiteren günstigen Ausführungsform ist zumindest eine Versteifung elliptisch, vorzugsweise kreisförmig ausgebildet. Durch diese kreisförmige Ausbildung ergibt sich eine gleichmäßige Krafteinleitung insbesondere bei einer Biegebeanspruchung der Anordnung.

Weiterhin ist eine solche Versteifung zur weiteren Verbesserung der Krafteinleitung derart ausgebildet, dass sie am Rand eine geringe Steifigkeit aufweist, welche zu einem inneren Bereich hin zunimmt. Dieser innere Bereich liegt vorzugsweise in der Mitte. Ebenso kann die Versteifung aber auch asymmetrisch ausgebildet sein.

Diese zunehmende Steifigkeit kann beispielsweise durch eine Scheibe mit radialen Schlitzen erreicht werden.

Ebenso kann dies auch durch eine vom Rand aus zunehmende Materialdicke erreicht werden. Alternativ kann aber auch eine zunehmende Materialdichte realisiert werden. Dabei könnte die Materialdicke annähernd konstant bleiben, was zu einer einfacheren Verarbeitbarkeit führt. Auch könnten in die Versteifung wieder andere Materialien, beispielsweise ein Kern aus einem oder mehreren Materialien mit höherer Steifigkeit eingebettet sein. Selbstverständlich können mehrere dieser Ausführungsformen miteinender kombiniert werden.

Eine weitere Ausgestaltung der Erfindung sieht vor, dass zusätzliche Schirmflächen vorgesehen sind, welche ein Eindringen der elektromagnetischen Felder in unerwünschte Bereiche anderer Teile des MRT-Gerätes wie beispielsweise der Gradientenspulen oder in den Patienten verhindern. Diese Schirmflächen können wahlweise aus getrennten Schichten aus leitfähigem Material oder auf Schichten gemeinsam mit den Spulen angebracht sein.

In einer anderen Ausgestaltung der Erfindung weisen zumindest einige der leitenden Flächen Schlitze auf, um die Wirbelströme verursacht durch die äußeren Magnetfelder zu verringern. Derartige Schlitze können wahlweise in den Leitern der Spulen selbst, hierbei vorzugsweise in Längsrichtung, oder aber auch in den Schirmflächen vorgesehen sein.

Eine weitere Ausgestaltung sieht die parallele Führung mehrerer Leiter in voneinander getrennten leitenden Lagen vor, wobei die parallelen Leiter an bestimmten Stellen durch Durchkontaktierungen miteinander verbunden sind. Durch die parallele Führung der Leiter lässt sich eine höhere Güte der Spulen erreichen. Weiterhin können auch die Wirbelströme reduziert werden.

Weiter ist es vorteilhaft wenn die leitenden Flächen ein Material aufweisen, welches einen möglichst niedrigen ohmschen Widerstand und gleichzeitig bevorzugt eine möglichst niedrige magnetische Konstante µr besitzt. Ein solches Material ist beispielsweise Silber. Es sind auch Kombinationen mit anderen leitfähigen Materialien möglich. So kann die leitende Schicht im Inneren aus Kupfer bestehen, welches an seiner Außenseite mit einer dünnen Silberschicht versehen ist. Da der Strom bei hohen Frequenzen durch den Skineffekt überwiegend auf der Außenseite des Leiters fließt, kann man hierdurch auch Spulen mit geringen Verlusten und so mit hohen Güten realisieren.

Bevorzugterweise wird die Oberfläche der leitenden Schichten mit einer möglichst geringen Rauhigkeit bzw.

Rautiefe, vorzugsweise <1µm ausgebildet. Auch diese Maßnahme trägt zur Reduzierung des Verlustwiderstandes bei. Die Herstellung einer glatten Oberfläche kann beispielsweise durch Elektropolieren oder Walzen erfolgen.

In einer weiteren Ausgestaltung der Erfindung wird wenigstens eine leitende Schicht als Metallfolie vorgefertigt, wobei bei dieser vorteilhafterweise die Oberflächen geglättet und /oder mit einer gut leitfähigen Schicht, beispielsweise aus Silber versehen werden. Diese vorgefertigte Schicht wird dann durch Pressen mit einer isolierenden Schicht verbunden.

In einer weiteren vorteilhaften Ausgestaltung der Erfindung sind weitere elektronische Bauteile, wie beispielsweise Kapazitäten in Form von Leitern ausgebildet. So lassen sich auf einfache Weise Kapazitäten durch die Anordnung von zwei leitenden Flächen, getrennt durch eine isolierende Fläche realisieren. Ebenso sind auf diese Weise besonders einfach Richtköppler, Baluns oder auch andere Symmetrierelemente, sowie Hybrids bzw. Leistungsteiler realisierbar.

Eine weitere Ausgestaltung der Erfindung sieht vor, dass diskrete elektronische Bauelemente, wie beispielsweise Spulen, Kondensatoren, Widerstände, Halbleiter auf der Anordnung angebracht und beispielsweise durch Löten oder Bonden mit wenigstens einer leitenden Fläche verbunden sind, bzw. in isolierende Schichten eingebettet sind.

Eine weitere Ausgestaltung der Erfindung sieht vor, dass zumindest eine isolierende Schicht Bereiche aus einem durchsichtigen Material aufweist. Somit können in der Spulenanordnung Öffnungen geschaffen werden, durch welche das medizinische Personal auf die zu untersuchenden Körperteile blicken kann. Dies ermöglicht eine visuelle Untersuchung sowie eine exakte Justage. Weiterhin ist es möglich, derart zumindest teilweise durchsichtige Spulenanordnungen im Kopfbereich von Patienten anzuordnen, da diese dann zumindest durch die Öffnungen hindurchblicken können. Ebenso können auch Öffnungen, beispielsweise für Operationsinstrumente vorgesehen sein.

Eine weitere Ausgestaltung der Erfindung sieht vor, dass die gesamte Anordnung in Form einer ebenen Leiterplatte hergestellt wird und anschließend in eine erforderliche dreidimensionale Form gebogen wird. Alternativ kann auch eine flexible Leiterplatte eingesetzt werden. So kann beispielsweise eine ebene Platte in Form eines Zylinders gebogen werden. Diese kann dann zur zusätzlichen mechanischen Fixierung auf einen weiteren Träger, beispielsweise ebenfalls in Zylinderform aufgebracht werden.

In einer weiteren Ausgestaltung der Erfindung wird zunächst ein Formkörper aus Isoliermaterial in der gewünschten Grundform hergestellt. Dieser wird in einem weiteren Fertigungsschritt dann mit den entsprechenden Leitern versehen. Eine solche Fertigungstechnologie ist insbesondere bei massiven Leitern mit Dicken von mehreren Millimetern sinnvoll einzusetzen.

In einer weiteren Ausgestaltung der Erfindung sind zusätzliche Kanäle zur Führung von wenigstens einem Kühlmedium in der Anordnung vorgesehen. Ein Kühlmedium kann beispielsweise Wasser oder eine wässrige Lösung sein. Vorzugsweise wird jedoch ein Medium ohne Wasserstoffatome, besonders bevorzugt eine aprotische Flüssigkeit verwendet, um Beeinträchtigungen durch Resonanzen der Wasserstoffatome zu vermeiden. Zur Führung des Kühlmediums können Kanäle wahlweise in einer isolierenden oder in einer leitfähigen Schicht ausgebildet sein. Ebenso können auch Rohre, welche wahlweise rund, aber bevorzugt rechteckig ausgebildet sind auf oder in der Anordnung angebracht werden.

Eine weitere vorteilhafte Ausgestaltung der Erfindung sieht zusätzliche Schirmflächen vor, welche zur Unterdrückung von Wirbelströmen Schlitze aufweisen. Derartige Schirmflächen sind beispielsweise in der US 2003/0071621 A1 sowie in der US 4,871,969 offenbart. Zur besseren Schirmung können auch unterschiedliche Bereiche durch Leiterbahnen, welche durch eine isolierende Schicht von den Schirmflächen getrennt sind, miteinander verbunden werden.

Die Erfindung bezieht sich ebenfalls auf ein Kernspintomographen mit einer der zuvor beschriebenen HF-Spulen.

Weiterhin wird erfindungsgemäß eine Schirmvorrichtung beschrieben, welche besonders platzsparend in Kernspintomographen integrierbar ist. Eine Schicht aus isolierendem Material ist auf beiden Seiten mit kleinflächigen Segmenten aus elektrisch leitfähigem Material beschichtet. So können diese Segmente beispielsweise kreisförmig, rechteckig, quadratisch oder auch sechseckig sein. Besonders vorteilhaft ist beispielsweise eine rechteckige oder auch sechseckige Ausgestaltung, so dass die Flächen mit minimalem Abstand aneinandergereiht werden können. Um nun eine möglichst gute Schirmung zu erreichen, sind die leitfähigen Flächenelemente auf der Oberseite und der Unterseite des isolierenden Materials gegeneinander versetzt. Durch den Versatz lässt sich eine gute kapazitive Kopplung zwischen Oberseite und Unterseite erreichen, so dass sich für hochfrequente Signale eine Schirmwirkung ergibt. Die Kapazität zwischen den Flächenelementen sollte möglicht groß sein. Gleichzeitig werden aufgrund der kleinen Flächen, welche voneinander getrennt sind durch die äußeren starken Magnetfelder nur geringe Wirbelströme induziert. Besonders vorteilhaft ist es, solche Schirmflächen in Verbindung mit Sende- und Empfangsantennen einzusetzen, da diese dann besonders einfach dimensioniert und platzsparend aufgebaut werden können. So kann beispielsweise in einem mehrschichtigen Aufbau gemeinsam die zuvor beschriebene Schirmung zusammen mit den entsprechenden Sende- und Empfangsantennen in anderen Schichten ausgebildet sein.

Vorteilhaft ist es jedenfalls, wenn die Segmente zumindest einer Fläche, oder aber auch mehrerer Flächen untereinander galvanisch miteinander verbunden sind. Um hier die Wirbelströme zu reduzieren, erfolgt die Verbindung vorzugsweise hochohmig, beispielsweise durch eine hochohmige Leiterschicht, welche über, unter oder zwischen den Segmenten angebracht ist.

Erfindungsgemäß sind auch mehrere der hier beschriebenen Ausführungsformen miteinander kombinierbar.

### Beschreibung der Zeichnungen

Die Erfindung wird nachstehend ohne Beschränkung des allgemeinen Erfindungsgedankens anhand von Ausführungsbeispielen unter Bezugnahme auf die Zeichnungen exemplarisch beschrieben.
Fig. 1 zeigt in allgemeiner Form schematisch eine Vorrichtung zur Kernspintomographie.
Fig. 2 zeigt eine erfindungsgemäße Spulenanordnung im Schnitt.
Fig. 3 zeigt eine erfindungsgemäße Spulenanordnung in der Draufsicht.
Fig. 4 zeigt eine besondere Ausführungsform einer Versteifung.
Fig. 5 zeigt eine weitere Ausführungsform, bei der die Ausschweifung gleichzeitig zur mechanischen Verbindung mehrerer Träger dient.
Fig. 6 zeigt eine Ausgestaltung mit Überlappung der Anordnung.
Fig. 7 zeigt eine Ausgestaltung mit Verzahnung der Anordnung
Fig. 8 zeigt eine Anordnung mit einer kreisförmigen Versteifung mit zur Mitte hin zunehmender Dicke.
Fig. 9 zeigt eine erfindungsgemäße Spulenanordnung mit mehrlagigem Schichtaufbau im Schnitt.
Fig. 10 zeigt eine erfindungsgemäße Anordnung mit einer schaumförmigen oder wabenformigen Isolationsschicht.
Fig. 11 zeigt eine erfindungsgemäße Schirmanordnung in der Draufsicht.
Fig. 12 zeigt eine besondere Ausführungsform eines Schirmelements.

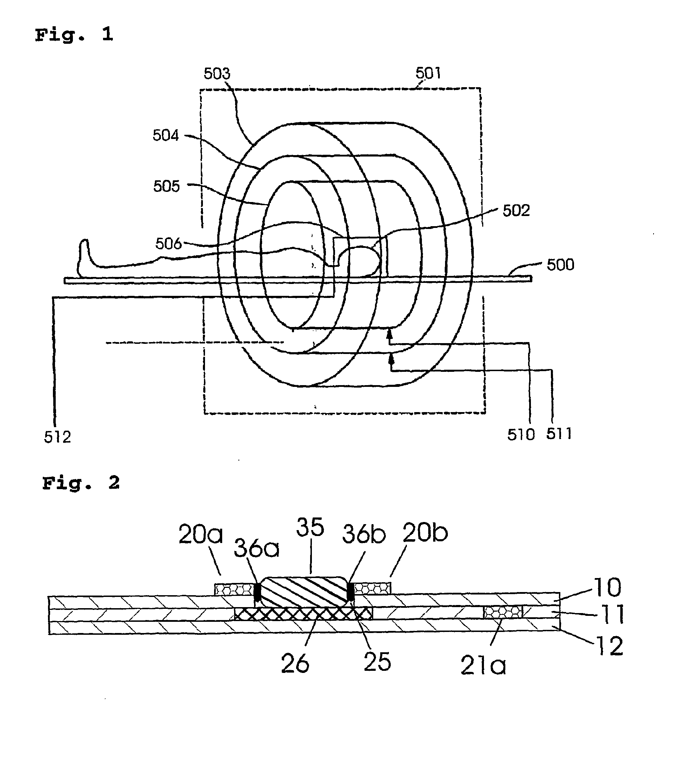

Fig. 1 zeigt in allgemeiner Form schematisch eine Vorrichtung zur Kernspintomographie. Der Patient 502 liegt auf einer Liege 500 im Magnetsystem 501. An Stelle eines Patienten können auch Tiere oder beliebige Gegenstände untersucht werden. Ein Hauptmagnet 503 dient zur Erzeugung des statischen Hauptmagnetfeldes. Zur Ortsbestimmung werden zeitlich und örtlich variable Magnetfelder mittels der Gradientenspulen 504 erzeugt. Diese werden durch Gradientensignale 511 angesteuert. Das hochfrequente Feld zur Anregung der Kernspinresonanzen wird mit Hilfe des Sendesignals 510 durch die Sendespulen 505 in das zu untersuchende Objekt eingespeist. Die Erfassung der Messsignale 512 erfolgt mittels der Empfangsspulen 506. Wahlweise können Sendespulen und Empfangspulen räumlich miteinander kombiniert sein. Ebenso kann die dieselbe Spulenanordnung zuerst zur Signalaussendung und später zum Signalempfang verwendet werden. Die Empfangspulen 506 können auch im äußeren Bereich der Sendespulen 505 angeordnet sein. Ebenso können auch die Sendespulen 505 in der Nähe des zu untersuchenden Objekts, ähnlich wie die hier dargestellten Empfangspulen 506 angeordnet sein.

In Fig. 2 ist eine erfindungsgemäße Spulenanordnung im Schnitt dargestellt. Eine erste Spule mit den Leitern 20a und 20b ist in der ersten Leiterschicht ausgebildet. Diese Leiterschicht ist auf eine erste Isolatorschicht 10 laminiert. Auf der anderen Seite dieser ersten Isolatorschicht 10 ist eine weitere Leiterschicht zur Ausbildung einer zweiten Spule mit dem Leiter 21a vorgesehen. Selbstverständlich können beliebig viele Leiter in den Leiterschichten ausgebildet werden. Schließlich ist noch eine zweite Isolatorschicht 12 unterhalb der zweiten Leiterschicht vorgesehen. Auf diese Weise können nahezu beliebig viele Leiterschichten und Isolatorschichten miteinander kombiniert werden. Durch ein Verpressen während der Fertigung werden die Hohlräume zwischen den Isolatorschichten ebenfalls mit Isoliermaterial aus den darüber bzw, darunter liegenden Schichten mit Isoliermaterial, welche sich verformen, aufgefüllt. Ebenso können aber auch die Hohlräume mit einer eigenen Schicht aus Isoliermaterial aufgefüllt sein. In der ersten Isolatorschicht 10 ist eine Aussparung 25 vorgesehen, in welche ein diskretes Bauteil 35, hier beispielsweise ein SMD-Kondensator, eingesetzt ist. Dieses Bauteil ist über die beiden Lötverbindungen 36a und 36b mit den benachbarten Leitern 20a und 20b verbunden. Um die durch die Aussparung hervorgerufene Schwächung der Anordnung zu kompensieren und eventuelle Zugspannungen, wie sie durch thermische Ausdehnungen, oder auch aufgrund von Biegebeanspruchungen entstehen, von dem Bauteil 35 sowie den Lötverbindungen 36 fernzuhalten, ist eine Versteifung 26 in die Anordnung eingebettet.

Fig. 3 zeigt eine erfindungsgemäße Spulenanordnung in der Draufsicht. Eine erste Spule 30a sowie eine zweite Spule 30b sind mit einem diskreten Kondensator 35 verbunden. Zu Erhöhung der Steifigkeit ist die Versteifung 26 vorgesehen.

In Figur 4 ist eine besonders vorteilhafte Art der Versteifung dargestellt. Hierbei ist die Versteifung elliptisch, vorzugsweise kreisförmig ausgebildet. Dadurch ergibt sich eine gleichmäßige Krafteinleitung und die Gefahr von Spannungsrissen wird weiter reduziert.

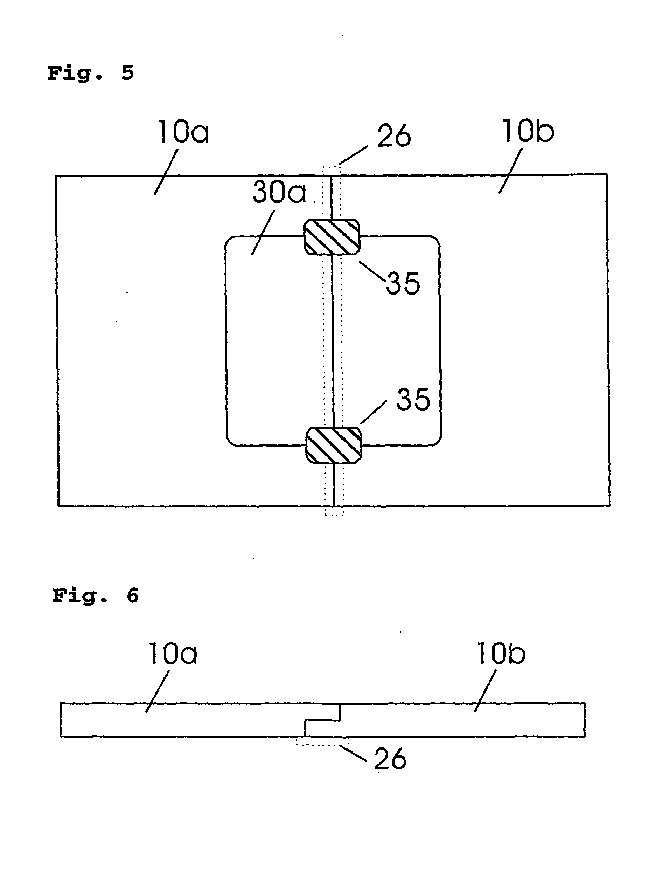

In Figur 5 ist eine weitere vorteilhafte Ausgestaltung der Versteifung dargestellt. Hierbei dient die Aussteifung gleichzeitig zur Verbindung zweier Trägerplatten beziehungsweise Schichten aus Isolationsmaterial 10a, 10b. Selbstverständlich kann die Aussteifung 26 ebenso lang wie die Schichten aus Isolationsmaterial oder auch kürzer sein. Ein Überstand der Aussteifung wurde hier nur aus Gründen der Übersichtlichkeit gezeichnet.

Figur 6 zeigt eine stufenförmige Ausgestaltung der Schichten aus Isolationsmaterial, wobei sich beim Zusammenfügen ein Überlappungsbereich ergibt, so dass die Festigkeit des Verbundsystems besonders wird. Die Überlappung muss nicht unbedingt linear beziehungsweise mit konstantem Abstand erfolgen. Vielmehr kann diese auch variieren und insbesondere den Leiterschichten beziehungsweise den diskreten Bauteilen 35 angepasst werden. Die Versteifung 26 ist vorzugsweise als längliches Teil, beispielsweise als Kunsttoff - oder Metallprofil entlang der Grenze zwischen den beiden Schichten aus Isoliermaterial 10a und 10b angeordnet. Ebenso könnten hier auch anstelle der Schichten aus Isoliermaterial mehrschichtige Bauteile vorgesehen sein.

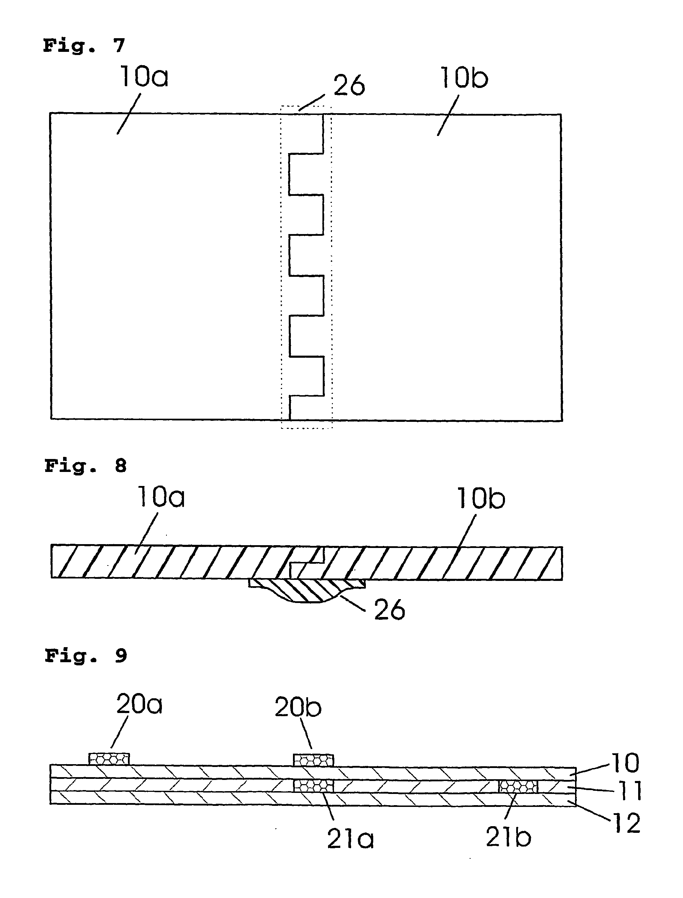

In Figur 7 ist noch eine Anordnung mit Verzahnung der beiden Schichten aus Isoliermaterial dargestellt, wodurch sich die mechanische Stabilität weiter erhöhen lässt. Besonders günstig ist eine Kombination mit der stufenförmigen Ausgestaltung aus Figur 6. Selbstverständlich sind auch beliebige Kombinationen der hier gezeigten Ausführungsformen möglich. Insbesondere können Versteifungen im Inneren der Schichten aus Isoliermaterial, als auch auf der Oberseite beziehungsweise Unterseite angebracht werden.

Figur 8 zeigt eine Anordnung mit einer kreisförmigen Versteifung mit zur Mitte hin zunehmender Dicke. Vorteilhafterweise sind dann entlang der Grenze zwischen den beiden Schichten aus Isoliermaterial 10a und 10b mehrere dieser Versteifungen angeodnet.

In Figur 9 ist eine erfindungsgemäße Spulenanordnung im Schnitt dargestellt. Eine erste Spule mit den Leitern 20a und 20b ist in der ersten Leiterschicht ausgebildet. Diese Leiterschicht ist auf eine erste Isolatorschicht 10 laminiert. Auf der anderen Seite dieser ersten Isolatorschicht 10 ist eine weitere Leiterschicht zur Ausbildung einer zweiten Spule mit den Leitern 21a und 21b vorgesehen. Selbstständig können beliebig viele Leiter in den Leiterschichten ausgebildet werden. Schließlich ist noch eine zweite Isolatorschicht 12 unterhalb der zweiten Leiterschicht vorgesehen. Auf diese Weise können nahezu beliebig viele Leiterschichten und Isolatorschichten miteinander kombiniert werden. Durch ein Verpressen während der Fertigung werden die Hohlräume zwischen den Isolatorschichten ebenfalls mit Isoliermaterial aus den darüber bzw. darunter liegenden Schichten mit Isoliermaterial, welche sich verformen, aufgefüllt. Ebenso können aber auch die Hohlräume mit einer eigenen Schicht aus Isoliermaterial, wie ein Beispiel unter dem Bezugszeichen 11 dargestellt, aufgefüllt werden.

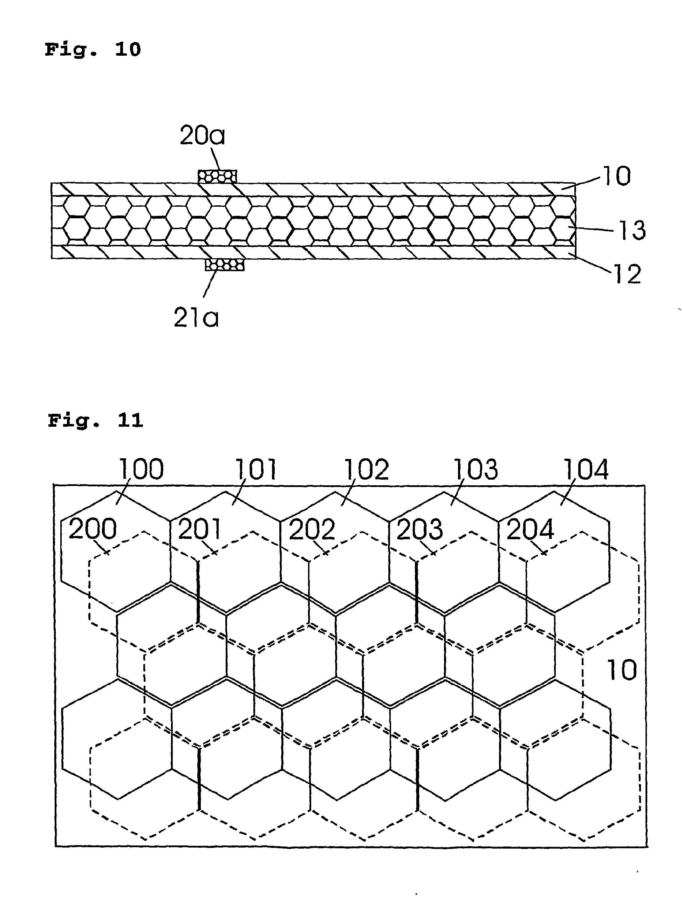

Figur 10 zeigt eine erfindungsgemäße Anordnung mit einer schaumförmigen oder wabenformigen Isolationsschicht 13. Diese ist eingebettet in zwei Kunststoffolien 10, 12, beispielsweise aus Polyimid. Dadurch ergibt sich eine ebene Oberfläche als Auflage für die Leiter 20a und 21a. Selbstverständlich können auch mehrere schaumförmige oder wabenformige Isolationsschichten eingesetzt werden. Voreteilhafterweise sind die Kunststoffolien 10, 12 fest, beispielsweise durch Kleben oder Laminieren, mit der schaumförmigen oder wabenformigen Isolationsschicht 13 verbunden. Alternativ ist jedoch wenigstens eine Kunststoffolien gegenüber der der schaumförmigen oder wabenformigen Isolationsschicht 13 beweglich bzw. verschiebbar, um eine exakte Justierung der leiter bzw. Spulen zu ermöglichen.

Figur 11 zeigt eine erfindungsgemäße Schirmanordnung in der Draufsicht. Auf der Oberseite einer ersten Isolatorschicht 10 sind in einer ersten Leiterschicht eine Vielzahl von Schirmflächen 100, 101, 102, 103, 104 angeordnet. Die Schirmflächen sind hier beispielhaft in der Form von Sechsecken ausgeführt, um eine möglichst große Flächenüberdeckung zu erreichen. Selbstverständlich könnten die Schirmflächen auch als Quadrate, Rechtecke, Kreise oder in anderer Form gestaltet sein. Weiterhin ist auf der Unterseite in einer zweiten Leiterschicht eine weitere Vielzahl von Schirmflächen 200, 201, 202, 203, 204 angeordnet. Diese sind Vorteilhafterweise gegenüber den anderen Schirmflächen versetzt, um eine kapazitive Verkopplung zwischen den Leiterschichten zu erreichen. Vorteilhafterweise werden mehrere solcher Leiterschichten jeweils getrennt durch Isolationsschichten angeordnet, um eine besonders gute Schirmung zu erreichen.

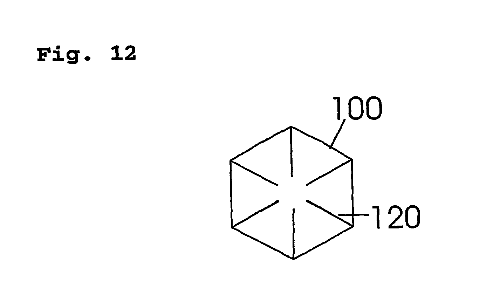

In Figur 12 ist eine besonders vorteilhafte Ausgestaltung einer Schirmfläche 100 dargestellt. Durch Schlitze 120 können hier die Wirbelströme weiter verringert werden.

### Bezugszeichenliste

- 10: erste Schicht aus Isolationsmaterial
- 11: Isolator zur Füllung des Zwischenraums zwischen Leitern
- 12: zweite Schicht aus Isolationsmaterial
- 13: Schicht aus schaumförmigem Isolationsmaterial
- 20: erste Leiterschicht
- 21: zweite Leiterschicht
- 25: Aussparung
- 26: Versteifung
- 30: induktive Komponente
- 35: diskretes Bauteil
- 36: Lötverbindung
- 100-104: Schirmfläche in einer ersten Leiterschicht
- 120: Schlitze in einer Schirmfläche
- 200-204: Schirmfläche in einer zweiten Leiterschicht
- 500: Patientenliege
- 501: Magnetsystem
- 502: Patient
- 503: Hauptmagnet
- 504: Gradientenspulen
- 505: Sendespulen ( HF-Spulen)
- 506: Empfangsspulen
- 510: Sendesignal
- 511: Gradientensignal
- 512: Messsignal

## Patentansprüche

1. HF-Spulenanordnung für Kernspintomographen umfassend wenigstens eine Schicht (10) aus Isolationsmaterial sowie darauf aufgebrachte elektrische Leiter zur Ausbildung einer oder mehrerer induktiver Komponenten (30), sowie wenigstens ein weiteres diskretes Bauelement (35), wobei die HF-Spulenanordnung als Leiterplatte ausgebildet ist,
**dadurch gekennzeichnet dass,**
in der Schicht (10) aus Isolationsmaterial Aussparungen (25) zur Aufnahme wenigstens eines diskreten Bauelements (35), sowie zusätzliche Versteifungen (26) vorgesehen sind.

2. HF-Spulenanordnung nach Anspruch 1,
**dadurch gekennzeichnet dass,**
die diskreten Bauelemente (35) wahlweise Kondensatoren, Spulen, Widerstände, Halbleiter wie Dioden umfassen.

3. HF-Spulenanordnung nach Anspruch 1,
**dadurch gekennzeichnet dass,**
wenigstens eine Versteifung (26) in Form von Streifen, Käfigen oder Ringen ausgebildet sind.

4. HF-Spulenanordnung nach Anspruch 1,
**dadurch gekennzeichnet dass,**
wenigstens eine Versteifung (26) ein Kunststoffmaterial umfasst.

5. HF-Spulenanordnung nach Anspruch 1,
**dadurch gekennzeichnet dass,**
mehrere Versteifungen (26) miteinander verbunden sind.

6. HF-Spulenanordnung nach Anspruch 1,
**dadurch gekennzeichnet dass,**
zumindest eine der Versteifungen (26) vorzugsweise durch Kleben an der Oberfläche des Trägers fixiert ist.

7. HF-Spulenanordnung nach Anspruch 1,
**dadurch gekennzeichnet dass,**
zumindest eine der Versteifungen (26) vorzugsweise durch Verpressen oder Eingießen in den Träger integriert ist.

8. HF-Spulenanordnung nach Anspruch 1,
**dadurch gekennzeichnet dass,**
zumindest eine Versteifung elliptisch, vorzugsweise kreisförmig ausgebildet ist.

9. HF-Spulenanordnung nach Anspruch 1,
**dadurch gekennzeichnet dass,**
zumindest eine Versteifung eine vom Rand ausgehend bis zur Mitte ansteigende Materialdicke aufweist.

10. HF-Spulenanordnung nach einem der vorhergehenden Ansprüche,
**dadurch gekennzeichnet dass,**
wenigstens eine Isolatorschicht (10) ein Schaumförmiges Material und/oder ein Material mit einer Wabenstruktur umfasst.

11. HF-Spulenanordnung nach einem der vorhergehenden Ansprüche,
**dadurch gekennzeichnet dass,**
wenigstens eine Isolatorschicht (10) einen mehrschichtigen Aufbau mit schaumfömigem Material und wenigstens einer Folie aus isolierendem Material und/oder Material mit einer Wabenstruktur umfasst.

12. HF-Spulenanordnung nach einem der vorhergehenden Ansprüche,
**dadurch gekennzeichnet dass,**
wenigstens eine weitere Leiterschicht (21) vorgesehen ist, welche durch wenigstens eine Isolatorschicht (10) von wenigstens einer anderen Leiterschicht (20) getrennt ist.

13. HF-Spulenanordnung nach einem der vorhergehenden Ansprüche,
**dadurch gekennzeichnet dass,**
verschiedene induktive Komponenten beziehungsweise Spulen in unterschiedlichen Leiterschichten (20,21) angeordnet sind und/oder wenigstens eine Speiseleitung für wenigstens eine Spule in wenigstens einer Leiterschicht der Anordnung ausgebildet ist.

14. HF-Spulenanordnung nach einem der vorhergehenden Ansprüche,
**dadurch gekennzeichnet dass,**
wenigstens eine Schirmfläche vorgesehen ist, welche das Eindringen der elektromagnetischen Felder in unerwünschte Bereiche anderer Teile des Kernspintomographen oder in den Patienten verhindern.

15. HF-Spulenanordnung nach einem der vorhergehenden Ansprüche,
**dadurch gekennzeichnet dass,**
wenigstens einige der leitenden Flächen in einer Leiterschicht Schlitze aufweisen, um die Wirbelströme verursacht durch die äußeren Magnetfelder zu verringern.

16. HF-Spulenanordnung nach einem der vorhergehenden Ansprüche,
**dadurch gekennzeichnet dass,**
elektrische Leiter in mehreren Leiterschichten parallel geführt sind und diese an bestimmten Stellen durch Durchkontaktierungen miteinander verbunden sind.

17. HF-Spulenanordnung nach einem der vorhergehenden Ansprüche,
**dadurch gekennzeichnet dass,**
wenigstens eine Leiterschicht ein Material mit einer möglichst hohen elektrische Leitfähigkeit und einer möglichst niedrigen magnetischen Konstante aufweist und/oder wenigstens eine Leiterschicht eine Oberfläche mit niedriger Rauhigkeit bzw. Rautiefe, vorzugsweise kleiner 1, als Mikrometer aufweist.

18. HF-Spulenanordnung nach einem der vorhergehenden Ansprüche,
**dadurch gekennzeichnet dass,**
wenigstens eine Leiterschicht als Metallfolie ausgebildet ist, deren Oberfläche vorzugsweise geglättet und/oder mit einer Oberflächenbeschichtung hoher Leitfähigkeit versehen ist.

19. HF-Spulenanordnung nach einem der vorhergehenden Ansprüche,
**dadurch gekennzeichnet dass,**
weitere elektronische Bauteile, wie beispielsweise Induktivitäten, Kapazitäten, Richtkoppler, Baluns, Hybrids oder andere Leistungsteiler in Form von Leitern in wenigstens einer Leiterschicht ausgebildet sind.

20. HF-Spulenanordnung nach einem der vorhergehenden Ansprüche,
**dadurch gekennzeichnet dass,**
weitere elektronische Bauteile, wie beispielsweise Induktivitäten, Kapazitäten, Widerstände, Halbleiter auf der Anordnung angebracht und Vorteilhafterweise in isolierende Schichten eingebettet sind.

21. HF-Spulenanordnung nach einem der vorhergehenden Ansprüche,
**dadurch gekennzeichnet dass,**
wenigstens eine Isolatorschicht Bereiche aus einem durchsichtigen Material aufweist.

22. HF-Spulenanordnung nach einem der vorhergehenden Ansprüche,
**dadurch gekennzeichnet dass,**
die HF-Spulenanordnung vorzugsweise als flexible Leiterplatte hergestellt ist.

23. HF-Spulenanordnung nach einem der vorhergehenden Ansprüche,
**dadurch gekennzeichnet dass,**
die HF-Spulenanordnung einem Formkörper umfassend eine erste Isolatorschicht in der gewünschten Grundform sowie wenigstens eine darauf aufgebrachte Leiterschicht aufweist.

24. HF-Spulenanordnung nach einem der vorhergehenden Ansprüche,
**dadurch gekennzeichnet dass,**
die HF-Spulenanordnung Kanäle zur Führung eines Kühlmediums aufweist.

25. HF-Spulenanordnung nach einem der vorhergehenden Ansprüche umfassend einen Schirm,
**dadurch gekennzeichnet dass,**
eine erste Isolatorschicht (10) vorgesehen ist, welche auf wenigstens einer Seite kleinflächige Segmente (100) aus elektrisch leitfähigem Material aufweist.

26. HF-Spulenanordnung nach Anspruch 25,
**dadurch gekennzeichnet dass,**
wenigstens eine weitere Leiterschicht (21) aus kleinflächigen Segmenten (100) vorgesehen ist, welche durch wenigstens eine Isolatorschicht von weiteren kleinflächigen Segmenten (100) getrennt ist, wobei die Schichten so angeordnet sind, dass sich die Segmente vorzugsweise seitlich überlappen.

27. HF-Spulenanordnung nach einem der Ansprüche 25 oder 26,
**dadurch gekennzeichnet dass** sie einen Schirm umfasst, in dem
mehrere kleinflächige Segmente (100) vorzugsweise hochohmig elektrisch miteinander verbunden sind.

28. Kernspintomograph mit einer HF-Spulenanordnung nach einem der vorhergehenden Ansprüche.

## Claims

1. RF coil arrangement for a magnetic resonance imaging scanner, comprising:
at least one layer (10) of insulating material, and also electrical conductors mounted thereon to form one or a plurality of inductive components (30), and
also at least one further discrete component part (35), with the RF coil arrangement being designed to be a printed circuit board,
**characterized in that**
recessed portions (25) for accommodating at least one discrete component part (35) are provided in the layer (10) of insulating material, and additional reinforcements (26) are provided.

2. RF coil arrangement according to claim 1,
**characterized in that**
the discrete component parts (35) optionally comprise capacitors, coils, resistors, and semiconductors such as diodes.

3. RF coil arrangement according to claim 1,
**characterized in that**
at least one reinforcement (26) is shaped as a strip, cage or ring.

4. RF coil arrangement according to claim 1,
**characterized in that**
at least one reinforcement (26) comprises a synthetic material.

5. RF coil arrangement according to claim 1,
**characterized in that**
a plurality of reinforcements (26) are joined together.

6. RF coil arrangement according to claim 1,
**characterized in that**
at least one of the reinforcements (26) is fixed to the surface of the support, preferably by adhesive bonding.

7. RF coil arrangement according to claim 1,
**characterized in that**
at least one of the reinforcements(26) is incorporated in the support, preferably by being pressed-in or cast-in.

8. RF coil arrangement according to claim 1,
**characterized in that**
at least one reinforcement (26) is shaped to be elliptical, preferably circular.

9. RF coil arrangement according to claim 1,
**characterized in that**
the thickness of the material of at least one reinforcement increases starting from its edge up to its middle.

10. RF coil arrangement according to any one of the preceding claims,
**characterized in that**
at least one insulator layer (10) comprises a foam-like material and/or a material having a honeycomb structure.

11. RF coil arrangement according to any one of the preceding claims,
**characterized in that**
at least one insulator layer (10) comprises a multi-layer structure with a foam-like material and at least one foil of insulating material and/or material having a honeycomb structure.

12. RF coil arrangement according to any one of the preceding claims,
**characterized in that**
at least one further conductor layer (21) is provided, which layer is separated from at least one other conductor layer (20) by at least one insulator layer (10).

13. RF coil arrangement according to any one of the preceding claims,
**characterized in that**
various inductive components or coils are disposed in different conductor layers (20, 21), and/or at least one supply line for at least one coil is formed in at least one conductor layer of the arrangement.

14. RF coil arrangement according to any one of the preceding claims,
**characterized in that**
at least one screening face is provided, which prevents electromagnetic fields from entering into undesired regions of other parts of the magnetic resonance imaging scanner or into a patient.

15. RF coil arrangement according to any one of the preceding claims,
**characterized in that**
at least some of the conducting faces in a conductor layer have slits in order to decrease eddy currents caused by the outer magnetic fields.

16. RF coil arrangement according to any one of the preceding claims,
**characterized in that**
electrical conductors in a plurality of conductor layers are arranged in parallel, and are connected to each other at particular locations via feed-through connections.

17. RF coil arrangement according to any one of the preceding claims,
**characterized in that**
at least one conductor layer comprises a material with as high as possible an electrical conductivity and as low as possible a magnetic constant, and/or at least one conductor layer has a surface of low roughness or peak-to-valley height, preferably of less than 1 micrometer.

18. RF coil arrangement according to any one of the preceding claims,
**characterized in that**
at least one conductor layer is designed as a metal foil, the surface of which is preferably smoothed and/or provided with a surface coating of high conductivity.

19. RF coil arrangement according to any one of the preceding claims,
**characterized in that**
further electronic components, such as for example inductances, capacities, directional couplers, baluns, hybrids or other power dividers are designed in the form of conductors in at least one conductor layer.

20. RF coil arrangement according to any one of the preceding claims,
**characterized in that**
further electronic components, such as for example inductances, capacities, resistors, semi-conductors, are mounted on the arrangement and preferably embedded in insulating layers.

21. RF coil arrangement according to any one of the preceding claims,
**characterized in that**
at least one insulator layer comprises regions of a transparent material.

22. RF coil arrangement according to any one of the preceding claims,
**characterized in that**
the RF coil arrangement is preferably fabricated to be a flexible printed circuit board.

23. RF coil arrangement according to any one of the preceding claims,
**characterized in that**
the RF coil arrangement has a shaped body comprising a first insulator layer of a desired basic shape, and also at least one conductor layer applied thereon.

24. RF coil arrangement according to any one of the preceding claims,
**characterized in that**
the RF coil arrangement has channels for conducting a cooling medium.

25. RF coil arrangement according to any one of the preceding claims, comprising a screen,
**characterized in that**
a first insulator layer (10) is provided which comprises small-area-segments (100) of electrically conducting material on at least one side.

26. RF coil arrangement according to claim 25,
**characterized in that**
at least one further conductor layer (21) of small-area-segments (100) is provided, which is separated from further small-area-segments (100) by at least one insulator layer, with the layers being disposed so that the segments preferably overlap laterally.

27. RF coil arrangement according to any one of claims 25 or 26,
**characterized in that**
it comprises a screen in which a plurality of small-area-segments (100) are preferably electrically connected to each other via high ohmic resistance.

28. Magnetic resonance imaging scanner with an RF coil arrangement according to any one of the preceding claims.

## Revendications

1. Disposition de bobine HF pour imageurs à résonance magnétique comprenant au moins une couche (10) de matériau isolant et des conducteurs électriques disposés sur celle-ci pour former un ou plusieurs composants inductifs (30), ainsi qu'au moins un autre composant discret (35), laquelle disposition de bobine HF est conformée comme une carte de circuits,
**caractérisée en ce qu'**il est prévu dans la couche (10) de matériau isolant des creux (25) pour recevoir au moins un élément discret (35), ainsi que des raidisseurs (26) supplémentaires.

2. Disposition de bobine HF selon la revendication 1, **caractérisée en ce que** les éléments discrets (35) comprennent au choix des condensateurs, des bobines, des résistances, des semi-conducteurs tels que des diodes.

3. Disposition de bobine HF selon la revendication 1, **caractérisée en ce qu'**au moins un raidisseur (26) est réalisé sous la forme de bandes, de cages ou d'anneaux.

4. Disposition de bobine HF selon la revendication 1, **caractérisée en ce qu'**au moins un raidisseur (26) comprend une matière plastique.

5. Disposition de bobine HF selon la revendication 1, **caractérisée en ce que** plusieurs raidisseurs (26) sont reliés entre eux.

6. Disposition de bobine HF selon la revendication 1, **caractérisée en ce qu'**au moins un des raidisseurs (26) est fixé sur la surface du support, de préférence par collage.

7. Disposition de bobine HF selon la revendication 1, **caractérisée en ce qu'**au mois un des raidisseurs (26) est de préférence intégré dans le support par pressage ou coulée.

8. Disposition de bobine HF selon la revendication 1, **caractérisée en ce qu'**au moins un raidisseur a une forme elliptique, de préférence circulaire.

9. Disposition de bobine HF selon la revendication 1, **caractérisée en ce qu'**au moins un raidisseur présente une épaisseur de matériau croissante du bord vers le milieu.

10. Disposition de bobine HF selon l'une des revendications précédentes, **caractérisée en ce qu'**au moins une couche d'isolant (10) comprend un matériau en mousse et/ou un matériau ayant une structure en nid d'abeilles.

11. Disposition de bobine HF selon l'une des revendications précédentes, **caractérisée en ce qu'**au moins une couche d'isolant (10) présente une structure à plusieurs couches avec du matériau en mousse et au moins une feuille de matériau isolant et/ou de matériau ayant une structure en nid d'abeilles.

12. Disposition de bobine HF selon l'une des revendications précédentes, **caractérisée en ce qu'**il est prévu au moins une autre couche conductrice (21) qui est séparée par au moins une couche d'isolant (10) d'au moins une autre couche conductrice (20).

13. Disposition de bobine HF selon l'une des revendications précédentes, **caractérisée en ce que** différents composants inductifs ou bobines sont disposés dans différentes couches conductrices (20, 21) et/ou au moins une ligne d'alimentation pour au moins une bobine est disposée dans au moins une couche conductrice de la disposition.

14. Disposition de bobine HF selon l'une des revendications précédentes, **caractérisée en ce qu'**il est prévu au moins une surface de blindage qui empêche la pénétration des champs électromagnétiques dans des zones non souhaitées d'autres parties de l'imageur à résonance magnétique ou dans le patient.

15. Disposition de bobine HF selon l'une des revendications précédentes, **caractérisée en ce qu'**au moins certaines des surfaces conductrices dans une couche conductrice présentent des fentes afin de réduire les courants de Foucault provoqués par les champs magnétiques externes.

16. Disposition de bobine HF selon l'une des revendications précédentes, **caractérisée en ce que** des conducteurs électriques sont posés en parallèle dans plusieurs couches conductrices et ceux-ci sont reliés entre eux en certains endroits par des contacts traversants.

17. Disposition de bobine HF selon l'une des revendications précédentes, **caractérisée en ce qu'**au moins une couche conductrice comporte un matériau ayant une conductivité électrique aussi élevée que possible et une constante magnétique aussi basse que possible et/ou au moins une couche conductrice présente une surface à faible rugosité ou faible profondeur de rugosité, de préférence inférieure à 1 micromètre.

18. Disposition de bobine HF selon l'une des revendications précédentes, **caractérisée en ce qu'**au moins une couche conductrice est réalisée sous la forme d'un film métallique dont la surface est de préférence lissée et/ou dotée d'un revêtement de surface à haute conductivité.

19. Disposition de bobine HF selon l'une des revendications précédentes, **caractérisée en ce que** d'autres composants électroniques, par exemple des inductances, des capacités, des coupleurs directionnels, des baluns, des hybrides ou autres diviseurs de puissance sont formés sous la forme de conducteurs dans au moins une couche conductrice.

20. Disposition de bobine HF selon l'une des revendications précédentes, **caractérisée en ce que** d'autres composants électroniques, par exemple des inductances, des capacités, des résistances, des semi-conducteurs sont disposés sur la disposition et de préférence inclus dans des couches isolantes.

21. Disposition de bobine HF selon l'une des revendications précédentes, **caractérisée en ce qu'**au moins une couche isolante comporte des zones faites d'un matériau transparent.

22. Disposition de bobine HF selon l'une des revendications précédentes, **caractérisée en ce que** la disposition de bobine HF est de préférence fabriquée sous la forme d'une carte de conducteurs flexible.

23. Disposition de bobine HF selon l'une des revendications précédentes, **caractérisée en ce que** la disposition de bobine HF présente un corps mis en forme comprenant une première couche isolante ayant la forme de base souhaitée ainsi qu'au moins une couche conductrice appliquée sur celle-ci.

24. Disposition de bobine HF selon l'une des revendications précédentes, **caractérisée en ce que** la disposition de bobine HF présente des canaux pour l'acheminement d'un fluide de refroidissement.

25. Disposition de bobine HF selon l'une des revendications précédentes comprenant un blindage, **caractérisée en ce qu'**il est prévu une première couche isolante (10) qui présente sur au moins un côté des segments de petite surface (100) faits de matériau conducteur électrique.

26. Disposition de bobine HF selon la revendication 25, **caractérisée en ce qu'**il est prévu au moins une autre couche conductrice (21) faite de segments de petite surface (100), qui est séparée par au moins une couche isolante d'autres segments de petite surface (100), les couches étant disposées de telle façon que les segments se chevauchent de préférence sur les côtés.

27. Disposition de bobine HF selon l'une des revendications 25 ou 26, **caractérisée en ce qu'**elle comprend un blindage dans lequel plusieurs segments de petite surface (100) sont reliés électriquement les uns aux autres, de préférence à haute impédance.

28. Imageur à résonance magnétique avec une disposition de bobine HF selon l'une des revendications précédentes.
